# EUROPEAN PATENT SPECIFICATION

(11) **EP 2 805 792 B1**
(45) Date of publication and mention of the grant of the patent: **20.09.2017**
(21) Application number: 13738641.3
(22) Date of filing: 08.01.2013
(51) Int. Cl.: B23K 35/36, B23K 35/362, B23K 35/02, H05K 3/34

(54) **FLUX FOR FLUX-CORED SOLDER, AND FLUX-CORED SOLDER**
FLUSSMITTEL FÜR RÖHRENLOT UND RÖHRENLOT
FLUX POUR BRASAGE AVEC FIL À ÂME DE FLUX, ET FIL À ÂME DE FLUX

(30) Priority: 17.01.2012 JP 2012007063
(43) Date of publication of application: 26.11.2014
(73) Proprietor: SENJU METAL INDUSTRY CO., LTD., Tokyo, 120-8555 (JP)
(72) Inventor: SUGIURA, Takao, Kariya-shi Aichi 448-8661 (JP); HIGASHIMURA, Yoko, Tokyo 120-8555 (JP); ONITSUKA, Motohiro, Tokyo 120-8555 (JP); KAWANAGO, Hiroshi, Tokyo 120-8555 (JP); TSURUTA, Kaichi, Tokyo 120-8555 (JP)
(74) Representative: D Young & Co LLP
(86) International application number: PCT/JP2013/050100
(87) International publication number: WO 2013/108663

(56) References cited:
- WO-A1-2006/070797
- JP-A- S5 554 298
- JP-A- S5 581 097
- JP-A- H07 100 690
- JP-A- 2001 170 796
- JP-A- 2001 170 796
- JP-A- 2002 336 992
- JP-A- 2010 046 689
- US-A1- 2010 139 952

## Description

### [TECHNICAL FIELD]

The present invention relates to flux used for flux cored solder and the flux cored solder.

### [BACKGROUND]

Any electrodes are formed so as to fit terminals such as pins of electronic parts on a board such as a printed circuit board on which the electronic parts are mounted. Fixation and electrical connection between the electronic parts and the board are performed by soldering. On such a board, ion migration (electrochemical migration) may occur when a waterdrop is attached between the electrodes to which direct voltage is applied.

The ion migration (hereinafter, referred to as "migration") refers to a phenomenon in which metal ions dissolved from a positive electrode receives any electrons at a negative electrode between the electrodes to which direct voltage is applied and deoxidized metal grows from the negative electrode, so that the deoxidized metal extends up to the positive electrode to short-circuit both electrodes. Thus, when the migration occurs by attaching a waterdrop or the like, both electrodes are short-circuited so that any functions as the board are lost.

Next, in general, flux used for soldering chemically removes any metallic oxides existed on the solder and the metal surface to be soldered at temperature under which the solder is melted. It has a property to enable metal elements to migrate through a boundary between them. By using the flux, it is possible to form intermetallic compound between the solder and basic material to obtain a strong connection.

The flux cored solder is a material in which the flux is sealed in wired solder and the soldering is performed by melting the solder by means of a soldering iron, a laser or the like.

The flux contains any components that are not decomposed or evaporated by heating of the soldering and they remain as a flux residue around a soldered portion after the soldering. Since rosin contained in the flux as a main ingredient has water repellency, the migration does not directly occur because of the water repellency of the rosin even if a waterdrop is attached on the flux residue when the flux residue containing the rosin as their main ingredient is formed on the soldered portion.

However, if a crack occurs in the flux residue, moisture enters into the soldered portion from the crack, which becomes a main cause of the occurrence of migration. Particularly, under a vibratory environment or an environment of violent temperature change, a crack is subject to an occurrence in the flux residue.

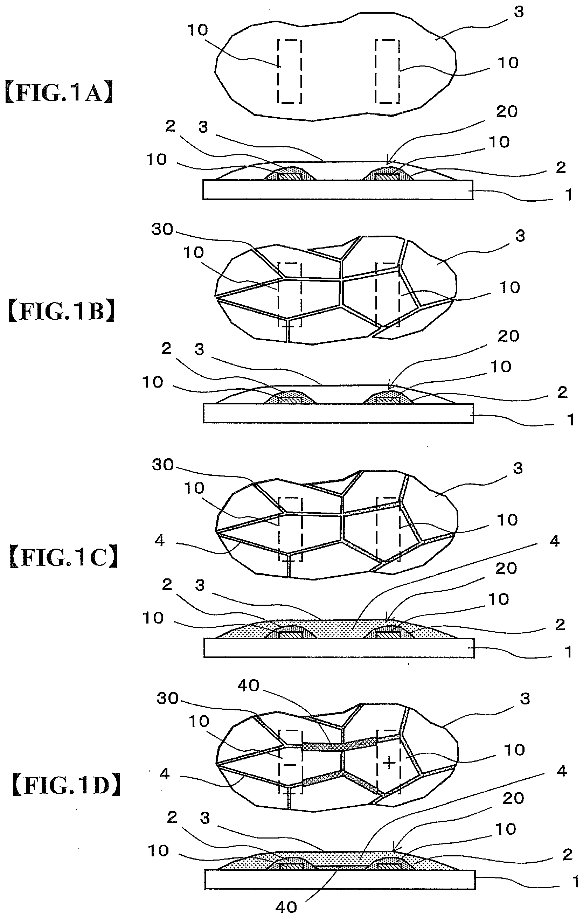

FIGS. 1A, 1B, 1C and 1D are diagrams for showing a developmental process of the migration based on the occurrence of cracks. FIG. 1A typically shows a condition where each soldered portion 20 in which the solder 2 is connected on each electrode 10 formed on the board 1 by soldering is covered by the flux residue 3.

As shown in FIG. 1B, if the waterdrop is attached on the soldered portion 20 in which the cracks 30 have occurred in the flux residue 3 because of temperature cycles in which it is exposed between a fixed high temperature and a fixed low temperature, the cracks 30 form water splits, as shown in FIG. 1C, so that water 4 enters into the soldered portion 20.

When the crack 30 reaches the solder 2 and the waterdrop is attached between the electrodes 10, 10 to which direct voltage is applied, the migration occurs between the electrodes 10, 10 to which the direct voltage is applied, as shown in FIG. 1D. In other words, metal ions dissolved from a positive electrode receives any electrons at a negative electrode and deoxidized metal grows from the negative electrode, so that both electrodes are short-circuited by the deoxidized metal 40 extending up to the positive electrode.

Further, although the flux residue is formed by hardening the flux expanded to a surface of the soldered portion during the soldering, there is a case where the flux is not expanded to a whole surface of the soldered portion, so that a part in which the soldered portion is covered by the flux residue and a part in which the soldered portion is not covered by the flux residue occur. In the part in which the soldered portion is not covered by the flux residue, the above-mentioned migration is caused to occur.

Additionally, when the surface of the soldered portion is not covered by the flux during the soldering, solder separation property deteriorates during the soldering by using the soldering iron.

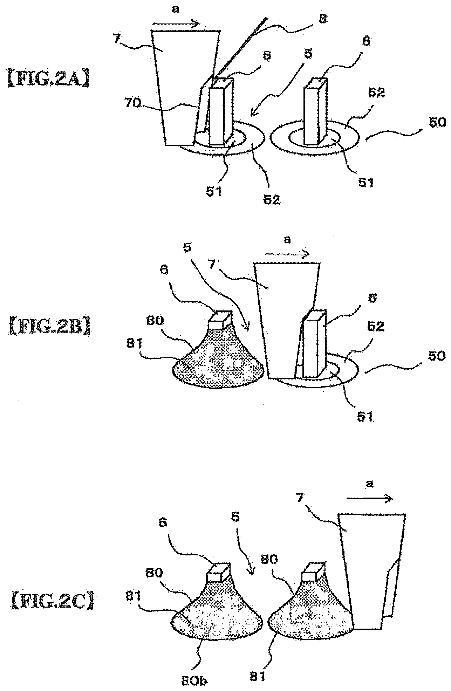

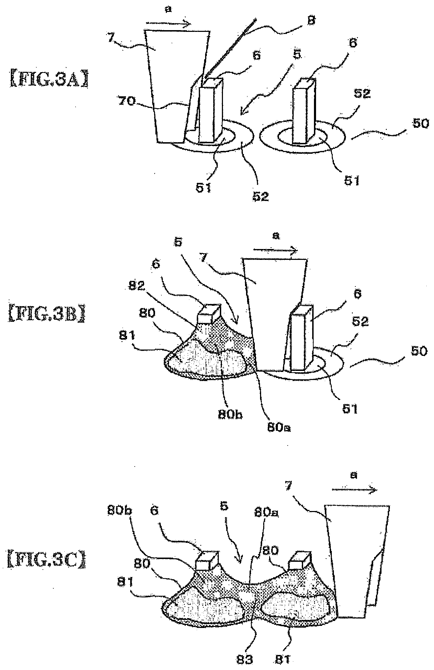

FIGS. 2A, 2B and 2C and FIGS. 3A, 3B and 3C are illustration diagrams showing an outline of the solder separation property. FIGS. 2A, 2B and 2C illustrate a good solder-cutting phenomenon and FIGS. 3A, 3B and 3C illustrate a poor solder-cutting phenomenon.

Explaining an outline of the soldered portion in which the solder separation property is problem, the soldered portion 5 has such a pattern that a land 52 is formed on a front surface of the board 50, which is one surface thereof, corresponding to a through-hole 51 passing through the board 50, in this example and a pin 6 of an electronic part, not shown, is inserted into the land 52. The board 50 is configured so that plural through-holes 51 and lands 52 are arranged in parallel corresponding to the arrangement of the pins 6 of the electronic parts, not shown, and the soldered portions 5 are arranged in a row.

The soldering iron 7, which is heating means, is formed to provide a groove 70 that allows the pins 60 to pass through it, at its forward end and by moving the soldering iron 7 to an arrow direction "a" along the arrangement of the pins 6 as shown in FIGS. 2A, 2B and 2C and FIGS. 3A, 3B and 3C, the soldering is successively performed on the plural soldered portions 5.

First, explaining the good solder-cutting phenomenon by referring to FIGS. 2A, 2B and 2C, flux cored solder 8 is melted when the heated soldering iron 7 moves to the arrow direction "a" as shown in FIG. 2A and the soldering iron 7 passes through the pin 6 to be soldered so that the land 52 and the pin 6 are connected to each other by the melted solder.

The flux sealed in the flux cored solder 8 contains any components that are not decomposed or evaporated by heating during the soldering and a surface of the solder 80 melted during the soldering are covered by the flux 81.

In a case of the solder having good solder separation property, by moving the heated soldering iron 7 to the arrow direction "a" as shown in FIG. 2A, the whole surface of each solder 80 is covered by the flux 81 during the soldering, as shown in FIG. 2B, which prevents the surface of the solder 80 from being oxidized.

By preventing the surface of the solder 80 from being oxidized during the soldering, a main cause of an obstruction to cutting of the solder 80a following the soldering iron 7 apart from the soldered portion 5 and the solder 80b remaining in the soldered portion 5 is removed by means of the operation to move the heated soldering iron 7 to solder the plural portions 5 to be soldered successively.

Thus, as shown in FIG. 2C, the solder 80a following the soldering iron 7 and the solder 80b remaining in the portion 5 to be soldered are easily cut by movement of the soldering iron 7 apart from the soldered portion 5 so that so-called solder separation property is improved. This suppresses an occurrence of a bridge by which the solder 80 is connected between the adjacent soldered portions 5.

In a case of the solder having the poor solder separation property, by moving the heated soldering iron 7 to the arrow direction "a" as shown in FIG. 3A, a whole surface of the solder 80 is not covered by the flux 81 during the soldering, as shown in FIG. 3B, so that a part of the surface of the solder 80, which is not covered by the flux 81, is oxidized to form an oxide film 82 thereon.

It is difficult for the oxide film 82 formed on the surface of the melted solder 80 to be cut by the movement of the soldering iron 7 apart from the soldered portion 5 in the operation of moving the heated soldering iron 7 to solder the plural portions 5 to be soldered successively.

Accordingly, as shown in FIG. 3C, it is difficult for the solder 80a following the soldering iron 7 apart from the soldered portion 5 and the solder 80b remaining in the soldered portion 5 to be cut, so that a bridge 83 by which the solder is connected between the adjacent soldered portions 5 is subject to occurring.

Next, in order to restrain the migration from occurring, a technology to prevent any cracks from occurring in the flux residue has been proposed and as the technology to prevent any cracks from occurring in the flux residue, a technology such that the flux residue has flexibility has been proposed (For example, see Patent Document 1).

### [DOCUMENT FOR PRIOR ART]

### [PATENT DOCUMENT]

Patent Document 1: Japanese Kouhyo Patent Publication No. 2010-515576

### [SUMMARY OF THE INVENTION]

### [PROBLEMS TO BE SOLVED BY THE INVENTION]

The flux disclosed in the Patent Document 1 is used for solder paste and since the soldering is performed on a reflow furnace or the like, it is unnecessary to consider any solder separation property, which is problem in a case of using the soldering iron during the soldering. On the other hand, the flux cored solder is also used for the soldering using laser in addition to the soldering by the soldering iron and in the flux used in the flux cored solder, it is necessary to consider the flux spattering, which is supposed because of quick heating by the laser, in the soldering using the laser in addition to the solder separation property in the soldering by the soldering iron.

Further, the flux used for the solder paste is pasty and a solvent for pasting the flux is added thereto while the flux used for the flux cored solder is solid so that the flux used for the solder paste cannot be used as the flux for the flux cored solder as it is.

The present invention solves such problems and has an object to provide flux for flux cored solder and the flux cored solder, which allows the flux residue to have flexibility, allows the solder separation property in the soldering using the soldering iron to be improved and allows the flux spattering to be suppressed even when quick heating by the laser is performed in the soldering using the laser, so that they can be used without depending on any soldering method.

### [MEANS FOR SOLVING THE PROBLEMS]

Inventors have found out such a fact that addition of high molecular compound allows the flux residue to have flexibility. They have also found out such a fact that by a combination of the high molecular compound for allowing the flux residue to have flexibility and preventing melt viscosity of the flux from being increased and the halide, it is possible to improve the solder separation property in the soldering using the soldering iron and to suppress the flux spattering even by quick heating by the laser in the soldering using the laser.

This invention relates to flux for flux cored solder containing rosin, high molecular compound that prevents melt viscosity of the flux from being increased and allows flux residue to have flexibility after heating by soldering, and halide that prevents melt viscosity of the flux from being increased and by a combination of the high molecular compound that allows the flux residue to have flexibility after the heating by the soldering, allows the flux to cover a surface of solder melted during the heating by the soldering, wherein the high molecular compound is any one of polyethylene wax, polyolefin-based resin, ethylene-acrylic acid copolymer, polyamide resin, polyimide resin, polypropylene, polybutadiene, and acrylic resin or their combination, the halide is any one of 2,2,2-tribromoethanol, tetrabromoethane, tetrabromobutane, dibromopropanol, n-2,3-dibromo-1,4-butanediol, trans-2,3-dibromo-2-butene-1,4-diol, tris(2,3-dibromopropyl)isocyanurate or their combination and the high molecular compound of not less than 40 weight % and not more than 60 weight % is contained and the amount of halide in the flux is one selected from the list of:
i. not less than 1.4 weight % and not more than 1.9 weight %; and
ii. not less than 2 weight % and not more than 4 weight %. Further, it is also preferable that the halide of not less than 2 weight % and not more than 4 weight % is contained and the high molecular compound of not less than 40 weight % and not more than 60 weight % is contained.

This invention also relates to flux cored solder in which flux is sealed in a wire solder, the flux containing rosin, high molecular compound that prevents melt viscosity of the flux from being increased and allows flux residue to have flexibility after heating by soldering, and halide that prevents melt viscosity of the flux from being increased and by a combination of the high molecular compound that allows the flux residue to have flexibility after the heating by the soldering, allows the flux to cover a surface of solder melted during the heating by the soldering, wherein the high molecular compound is any one of polyethylene wax, polyolefin-based resin, ethylene-acrylic acid copolymer, polyamide resin, polyimide resin, polypropylene, polyisoprene, polybutadiene, and acrylic resin or their combination, the halide is any one of 2,2,2-tribromoethanol, tetrabromoethane, tetrabromobutane, dibromopropanol, n-2,3-dibromo-1,4-butanediol, trans-2,3-dibromo-2-butene-1,4-diol, tris(2,3-dibromopropyl)isocyanulate or their combination and the high molecular compound of not less than 40 weight % and not more than 60 weight % is contained. and the amount of halide in the flux is one selected from the list consisting of:
i. not less than 1.4 weight % and not more than 1.9 weight %; and
ii. not less than 2 weight % and not more than 4 weight %.

### [EFFECTS OF THE INVENTION]

According to this invention, the flux residue has flexibility so that even in a case of usage under the environment of violent temperature change or the vibratory environment, it is possible to prevent any cracks from occurring in the flux residue. This prevents any moisture from penetrating the soldered portion so that it is capable of restraining an occurrence of the migration.

Further, the combination of the high molecular compound that allows the flux residue to have flexibility and prevents melt viscosity of the flux from being increased and the halide allows a whole surface of the solder melted during the soldering to be covered by the flux. Accordingly, in the soldering using the soldering iron as the heating means, based on the movement of the soldering iron apart from the soldered portion, it is easy to cut the solder following the soldering iron from the solder remaining in the soldered portion, so that it is possible to improve the solder separation property and to suppress an occurrence of bridge by which the solder is connected between the adjacent soldered portions. By the combination of the high molecular compound and the halide, it is also possible to suppress the flux spattering even when the quick heating by the laser is performed, in the soldering using the laser as the heating means.

### [BRIEF DESCRIPTION OF DRAWINGS]

[Figure 1A] FIG. 1A is a diagram for showing a developmental process of migration based on an occurrence of cracks.
[Figure 1B] FIG. 1B is a diagram for showing a developmental process of migration based on an occurrence of cracks.
[Figure 1C] FIG. 1C is a diagram for showing a developmental process of migration based on an occurrence of cracks.
[Figure 1D] FIG. 1D is a diagram for showing a developmental process of migration based on an occurrence of cracks.
[Figure 2A] FIG. 2A is an illustration diagram illustrating an outline of the solder separation property.
[Figure 2B] FIG. 2B is an illustration diagram illustrating the outline of the solder separation property.
[Figure 2C] FIG. 2C is an illustration diagram illustrating the outline of the solder separation property.
[Figure 3A] FIG. 3A is an illustration diagram illustrating an outline of the solder separation property.
[Figure 3B] FIG. 3B is an illustration diagram illustrating the outline of the solder separation property.
[Figure 3C] FIG. 3C is an illustration diagram illustrating the outline of the solder separation property.

### [EMBODIMENT FOR CARRYING OUT THE INVENTION]

The flux for flux cored solder according to this embodiment contains rosin, high molecular compound that prevents melt viscosity of the flux from being increased and allows flux residue to have flexibility after heating by soldering, and halide that by a combination of the above-mentioned high molecular compound that prevents the melt viscosity of the flux from being increased and allows the flux residue to have flexibility after the heating by the soldering, allows the flux to cover a surface of solder melted during the heating by the soldering. According to the invention the high molecular compound is any one of polyethylene wax, polyolefin-based resin, ethylene-acrylic acid copolymer, polyamide resin, polyimide resin, polypropylene, polybutadiene, and acrylic resin or their combination.

It is preferable that the halide is any one of 2,2,2-tribromoethanol, tetrabromoethane, tetrabromobutane, dibromopropanol, n-2,3-dibromo-1,4-butanediol tra-2,3-dibromo-2-butene-1,4-diol, tris(2,3-dibromopropyl)isocyanulate or their combination.

As described above, when forming the flux residue, which contains rosin having water repellency as a main ingredient thereof, on the soldered portion, the migration does not directly occur because of the water repellency of the rosin even if a waterdrop is attached on the flux residue.

In the flux cored solder according to this embodiment, in which a predetermined combination of a predetermined amount of the high molecular compound and a predetermined amount of the halide is added to the flux, the addition of the high molecular compound causes the flux residue formed on the surface of the soldered portion to have flexibility. This enables the occurrence of cracks based on temperature cycles, vibration or the like to be suppressed so that it is possible to inhibit any contact between the waterdrop and the metal and to restrain the migration from occurring.

Further, by the combination of the halide functioning as an activator and the high molecular compound that prevents melt viscosity of the flux from being increased and allows flux residue to have flexibility after heating by soldering, the flux expands into the basic material to be soldered during the soldering so that the whole surface of the solder is covered by the flux during the soldering, which prevent the surface of the solder from being oxidized.

By the suppression of the oxidation of the solder surface, it is easy to cut the solder following the soldering iron from the solder remaining in the soldered portion, based on the movement of the soldering iron apart from the soldered portion in the operation of melting the solder by heating by means of the soldering iron as the heating means and performing the soldering, so that it is possible to suppress an occurrence of bridge by which the solder is connected between the adjacent soldered portions. By the combination of the high molecular compound and the halide, it is also possible to suppress the flux spattering even when the quick heating by the laser is performed, in the operation of melting the solder by heating using the laser as the heating means and performing the soldering.

Here, based on an addition amount of the high molecular compound, properties and condition of the flux are changed. For example, when an addition amount of the polyethylene wax is little, the melt viscosity of the flux is increased, which causes fluidity of the flux to be deteriorated. In contrast, when the addition amount of the polyethylene wax is increased, it is possible to suppress the deterioration of fluidity in the flux but it is impossible to remove the oxidation film on the basic material surface to be soldered sufficiently, which causes wettability thereof to be deteriorated.

On the other hand, when an addition amount of the ethylene-acrylic acid copolymer is little, the wettability is deteriorated while the addition amount of the ethylene-acrylic acid copolymer is increased, the wettability is improved but the fluidity in the flux is deteriorated.

Thus, since quality of the flux varies based on components of the high molecular compound to be added and a large or small amount of the addition thereof, the addition of the high molecular compound allows the flux residue to have flexibility and maintains the function of removal of the oxidation film, which is necessary for the flux during the soldering, or the like. It is preferable that by taking the combination with the halide into consideration, the high molecular compound is selected and an addition amount of the high molecular compound is not less than 40 % by weigh and not more than 60 % by weight.

When an addition amount of the halide is little, the solder separation property is deteriorated while the addition amount of the halide is increased, any carrion occurs. Accordingly, the addition amount of the halide is not less than 2 % by weight and not more than 4 % by weight, particularly, not less than 1.4 % and not more than 1.9 %.

### EXECUTED EXAMPLES

### <About Addition Amount of Halide>

They prepared the flux of the executed examples and that of the comparison examples, which have compositions shown in following Table 1, and formed wire solders using the flux of the executed examples and that of the comparison examples. It is to be noted that the composition percentages in Table 1 are weight %. They also assessed solder separation property and corrosive nature based on addition or non-addition of high molecular compound and halide and addition amounts thereof.

The solder separation property was assessed on the basis of numbers of bridges generated when soldering plural parallel portions to be soldered, in this example, parallel 20 pins, in series under atmosphere by slide soldering. The corrosive nature was assessed under a copperplate corrosion test.

In the assessment of the solder separation property in Table 1, it was assessed as "○" where the numbers of bridges were zero; it was assessed as "Δ" where the numbers of bridges were 2 through 10; and it was assessed as "x" where the numbers of bridges were 10 or more. Further, in the assessment of the corrosive nature in Table 1, it was assessed as "○" where no corrosion was seen; it was assessed as "Δ" where some corrosion was seen; and it was assessed as "x" where the corrosion was seen.

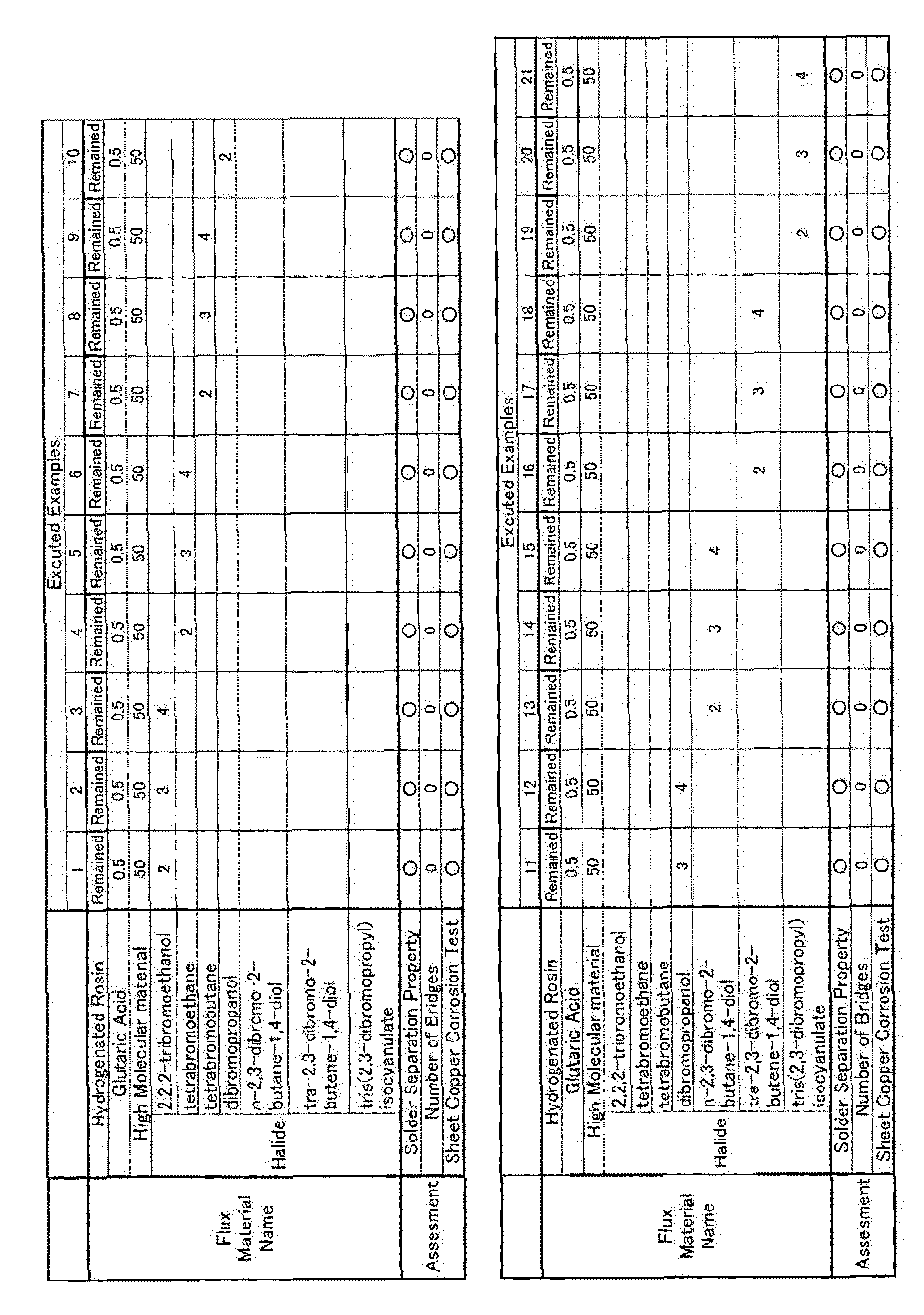

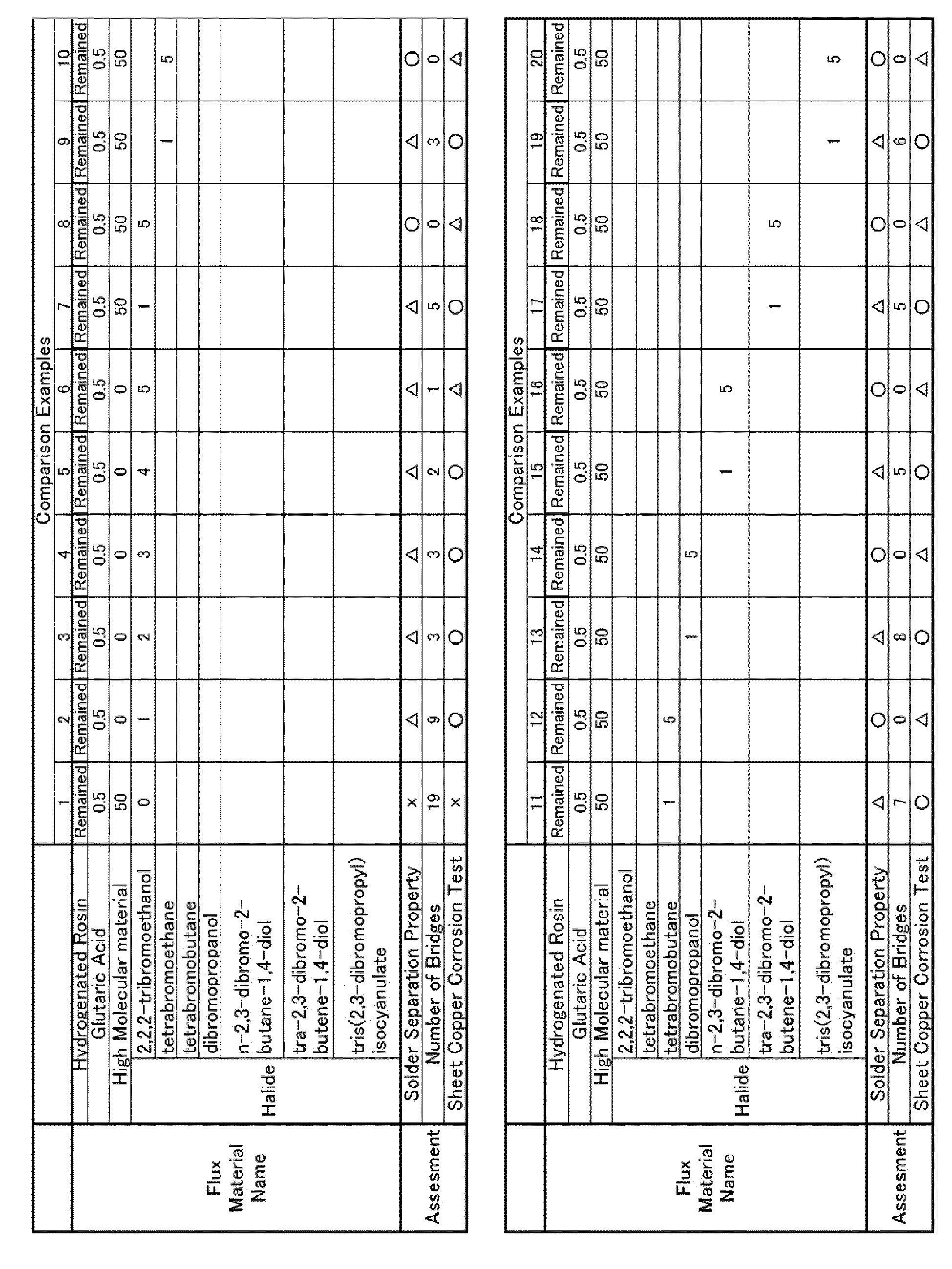

As shown in Table 1, it was seen that the flux of the comparison example 1 in which the high molecular compound was added and no halide was added has poor solder separation property and generates many bridges. It was also seen that the corrosion occurred.

In the flux of comparison examples 2 through 6, no high molecular compound was added and the solder separation property and the corrosive nature were assessed by changing the addition amount of the halide. In this example, the assessment was performed by changing the addition amount of the halide by stages in increments of 1 % between 1 % and 5 %.

In the comparison examples 2 through 6 in which the halide was added and no high molecular compound was added, it was seen that when the addition amount of the halide was increased, the numbers of bridges were decreased. However, it is understood that when the addition amount of the halide is increased, there is a tendency to generate any corrosion.

In the flux of comparison examples 7 through 20, while referring to the above assessment of the comparison examples, the assessment was performed by setting such that the high molecular compound was added and the addition amount of the halide was 1 % or 5 %. In the flux of comparison examples 7 through 20, it was seen that when the addition amount of the halide was 1%, no corrosion occurred but bridges occurred. It was also seen that when the addition amount of the halide was 5%, no bridge occurred but the corrosion occurred. Further, it is understood that the addition of high molecular compound allows flux residue to have flexibility and the addition of halide does not inhibit the flux residue from having any flexibility.

As described above, it is understood that there is an extent such that the addition of high molecular compound and a magnitude of the addition amount of halide enable the solder separation property to be improved and enable the occurrence of corrosion to be prevented.

Accordingly, in the flux of the executed examples 1 through 21, the high molecular compound was added and the assessment was performed by changing the addition amount of the halide by stages in increments of 1 % between 2 % and 4 %. In the flux of the executed examples 1 through 21, no bridge occurred in any cases and no corrosion occurred.

### <About Addition Amount of High Molecular Compound>

They prepared the flux of the executed examples and that of the comparison examples, which have compositions shown in following Table 2, and formed wire solders using the flux of the executed examples and that of the comparison examples. It is to be noted that the composition percentages in Table 2 are weight %. They assessed hardness of flux residue based on addition or non-addition of the high molecular compound and addition amounts thereof, and crack property of the flux residue. They also assessed the flux spattering when performing laser soldering and existence or nonexistence of failure of through-hole (TH) up when performing the laser soldering for applying it to the laser soldering in addition to the soldering by the soldering iron.

The hardness of flux residue was measured using a pencil scratch tester for coated film of JIS-K5400 after flux cored solder spread over the copperplate for five seconds to form the flux residue thereon and was kept at a constant temperature for one hour. The hardness under the pencil scratch tester for coated film was assessed on the basis of the hardness of lead of the pencil. In the assessment of the hardness of the flux residue in Table 2, it was assessed as "○" where the hardness of the flux residue was 5B or more; and it was assessed as "x" where the hardness of the flux residue was less than 5B.

In connection with the hardness of the flux residue, crack property of the flux residue in thermal shock cycle test was assessed by the crack property of the flux residue when the tests of repeating a process such that the flux residue formed on the copperplate was kept -30 degrees C for 30 minutes and a process such that the flux residue was kept +110 degrees C for 30 minutes performed 200 cycles. In the assessment of the crack property of the flux residue in Table 2, it was assessed as "○" where no crack was seen; it was assessed as "Δ" where a crack(s) was (were) partially seen; and it was assessed as "x" where the cracks were seen as a whole.

As another assessment for determining the addition amount of high molecular compound, spattering number when performing the laser soldering was assessed by the spattering number of flux on a board, which was generated when soldering by the laser soldering on plural parallel soldered portions, in this example, parallel 20 pins. In the assessment of the spattering number when performing the laser soldering in Table 2, it was assessed as "○" where the spattering numbers were less than three; it was assessed as "Δ" where the spattering numbers were not less than three and less than eight; and it was assessed as "x" where the spattering numbers were not less than eight. Furthermore, since the flux spattered on the soldered portion mixes the flux residue so that it was impossible to observe them, such flux was omitted from the assessment objects.

As other assessment for determining the addition amount of high molecular compound, the existence or nonexistence of failure of through-hole up when performing the laser soldering, was assessed by number of the failure of through-hole up, which was generated when soldering, in this example, parallel 20 pins as described above, by the laser soldering. In the assessment of the failure number of rise in through-hole when performing the laser soldering in Table 2, it was assessed as "○" where the failure numbers of rise in through-hole were less than three; it was assessed as "Δ" where the failure numbers of rise in through-hole were not less than three and less than six; and it was assessed as "x" where the failure numbers of rise in through-hole were not less than six.

**[Table 2]**

| | | Executed Examples | | | Comparison Examples | | | | | | | |
|---|---|---|---|---|---|---|---|---|---|---|---|---|
| | | 31 | 32 | 33 | 31 | 32 | 33 | 34 | 35 | 36 | 37 | 38 |
| Flux Material Name | Hydrogenated Rosin | Remained | Remained | Remained | Remained | Remained | Remained | Remained | Remained | Remained | Remained | 0 |
| | Glutaric Acid | 05 | 05 | 05 | 05 | 05 | 05 | 05 | 0.5 | 05 | 05 | 05 |
| | High Molecular material | 40 | 50 | 60 | 0 | 10 | 20 | 30 | 70 | 80 | 90 | 97.5 |
| | Halide | 2 | 2 | 2 | 2 | 2 | 2 | 2 | 2 | 2 | 2 | 2 |
| Assesment | Hardness of Residue | 5B | 6B | >6B | 2H | B | 3B | 4B | >6B | >6B | >6B | >6B |
| | Hardness Assessment | ○ | ○ | ○ | × | × | × | × | ○ | ○ | ○ | ○ |
| | Crack Property in Thermal Shock Cycle Test | ○ | ○ | ○ | × | × | × | Δ | ○ | ○ | ○ | ○ |
| | Failure Number of TH up when performing Laser Soldering | 0 | 0 | 1 | 0 | 0 | 0 | 0 | 5 | 7 | 8 | 12 |
| | Assessment of TH up | ○ | ○ | ○ | ○ | ○ | ○ | ○ | Δ | × | × | × |
| | Spattering Number when performing Laser Soldering | 1 | 0 | 0 | 12 | 7 | 7 | 4 | 0 | 0 | 0 | 0 |
| | Assessment of Spattering Number | ○ | ○ | ○ | × | Δ | Δ | Δ | ○ | ○ | ○ | ○ |

As shown in Table 2, in the flux of the comparison examples 31 through 34 of less addition amounts of the high molecule compound, the hardness of flux residue was hard and it was seen that the cracks occurred on the flux residue as a whole. Many spattering numbers of flux were also seen. In contrast, when increasing the addition amount of the high molecular compound by about 30 % by weight, there was seen a tendency such that the flux residue has flexibility so that it was found that occurrence of cracks was decreased. There was also seen a tendency of decreasing the spattering numbers of flux.

On the other hand, in the flux of the comparison examples 31 through 34 of less addition amounts of the high molecule compound, it was found that the failure numbers of rise in through-hole when performing the laser soldering were restrained.

As shown in Table 2, in the flux of the comparison examples 35 through 38 of much addition amounts of the high molecule compound, the hardness of flux residue was flexible and no occurrence of crack was seen. No flux spattering was also seen. However, in the flux of the comparison examples 35 through 38 of much addition amounts of the high molecule compound, many failure numbers of rise in through-hole when performing the laser soldering were seen.

From the above, it is understood that there is an extent in which the addition of the high molecular compound allows the flux residue to have flexibility, a magnitude of the addition amount of the high molecular compound also allows the flux residue to have flexibility, the flux spattering is suppressed even when performing rapid heating using the laser in the laser soldering, and the occurrence of the failure of through-hole up when performing the laser soldering is restrained.

Accordingly, in the flux of executed examples 31 through 33, the assessment was performed by changing the addition amount of the high molecular compound by stages in increments of 10 % between 40 % and 60 %. In the flux of the executed examples 31 through 33, the hardness of flux residue in any cases had a desired flexibility and no occurrence of crack based on temperature cycles was seen. Further, it is understood that the flux spattering is suppressed even when performing rapid heating using the laser in the laser soldering, and the occurrence in the failure of through-hole up when performing the laser soldering is restrained.

Form the above results, it is understood that in order that the addition of the high molecular compound and the halide to the flux allows the flux residue to have flexibility, allows the solder separation property to be improved and the corrosion by addition of the halide to be inhibited, in the soldering using the soldering iron and allows the flux spattering to be suppressed even when performing rapid heating using the laser and the occurrence in the failure of through-hole up to be restrained, in the laser soldering, it is preferable that the high molecular compound of not less than 40 % by weight and not more than 60 % by weight was added and the halide of not less than 2 % by weight and not more than 4 % by weight, preferably, the halide of not less than 1.4 % and not more than 1.9 % is added.

### [INDUSTRIAL APPLICABILITY]

The flux according to the invention is applicable to electronic equipment, such as electronic equipment mounted on a motor vehicle, used under the environment in which it can be influenced by any temperature change, vibration, water and dust.

### [DESCRIPTION OF CODES]

1...Board; 10...Electrode; 2...Solder; 20...Soldered Portion; 3...Flux Residue; 30...Crack; 4...Water; 5...Soldered Portion(Portion to be soldered); 50...Board; 51...Through-Hole; 52...Land; 6...Pin; 7...Soldering Iron; 8...Flux Cored Solder; 80...Solder; 81...Flux; 82...Oxide Film and 83... Bridge.

## Claims

1. Flux for flux cored solder containing:
rosin;
high molecular compound that prevents melt viscosity of the flux from being increased and allows a flux residue to have flexibility after heating by soldering; and
halide that prevents the melt viscosity of the flux from being increased and by a combination of the high molecular compound that allows the flux residue to have flexibility after the heating by the soldering, allows the flux to cover a surface of solder melted during the heating by the soldering,
wherein the high molecular compound is any one of polyethylene wax, polyolefin-based resin, ethylene-acrylic acid copolymer, polyamide resin, polyimide resin, polypropylene, polybutadiene, and acrylic resin or their combination, wherein the high molecular compound of not less than 40 weight % and not more than 60 weight % is contained,
the halide is any one of 2,2,2-tribromoethanol, tetrabromoethane, tetrabromobutane, dibromopropanol, n-2,3-dibromo-1,4-butanediol, trans-2,3-dibromo-2-butene-1,4-diol, tris(2,3-dibromopropyl)isocyanurate or their combination, and
the amount of halide in the flux is one selected from the list consisting of:
i. not less than 1.4 weight % and not more than 1.9 weight %; and
ii. not less than 2 weight % and not more than 4 weight %.

2. The flux for flux cored solder according to Claim 1 **characterized in that** the halide of not less than 2 weight % and not more than 4 weight % is contained.

3. Flux cored solder in which flux is sealed in a wire solder,
the flux containing:
rosin;
high molecular compound that prevents melt viscosity of the flux from being increased and allows flux residue to have flexibility after heating by soldering; and
halide that prevents melt viscosity of the flux from being increased and by a combination of the high molecular compound that allows the flux residue to have flexibility after heating by the soldering, allows the flux to cover a surface of solder melted during the heating by the soldering,
wherein the high molecular compound is any one of polyethylene wax, polyolefin-based resin, ethylene-acrylic acid copolymer, polyamide resin, polyimide resin, polypropylene, polybutadiene, and acrylic resin or their combination, wherein the high molecular compound of not less than 40 weight % and not more than 60 weight % is contained,
the halide is any one of 2,2,2-tribromoethanol, tetrabromoethane, tetrabromobutane, dibromopropanol, n-2,3-dibromo-1,4-butanediol, trans-2,3-dibromo-2-butene-1,4-diol, tris(2,3-dibromopropyl)isocyanurate or their combination; and
the amount of halide in the flux is one selected from the list consisting of:
i. not less than 1.4 weight % and not more than 1.9 weight %; and
ii. not less than 2 weight % and not more than 4 weight %.

## Patentansprüche

1. Flussmittel für Röhrenlot, umfassend:
Kolophonium;
eine hochmolekulare Verbindung, die Erhöhen der Schmelzviskosität des Flussmittels verhindert und einem Flussmittelrückstand Aufweisen von Flexibilität nach Erhitzen durch Löten ermöglicht; und
Halogenid, das Erhöhen der Schmelzviskosität des Flussmittels verhindert und durch eine Kombination mit der hochmolekularen Verbindung, die dem Flussmittelrückstand Aufweisen von Flexibilität nach dem Erhitzen durch Löten ermöglicht, dem Flussmittel ermöglicht, eine Oberfläche von während des Erhitzens durch das Löten geschmolzenem Lot zu bedecken,
wobei die hochmolekulare Verbindung eine von Polyethylenwachs, Harz auf Polyolefinbasis, Ethylen-Acrylsäure-Copolymer, Polyamidharz, Polyimidharz, Polypropylen, Polybutadien und Acrylharz oder deren Kombinationen ist, wobei die hochmolekulare Verbindung mit nicht weniger als 40 Gew.-% und nicht mehr als 60 Gew.-% enthalten ist,
das Halogenid eines von 2,2,2-Tribromethanol, Tetrabromethan, Tetrabrombutan, Dibrompropanol, n-2,3-Dibrom-1,4-butandiol, trans-2,3-Dibrom-2-buten-1,4-diol, Tris(2,3-dibrompropyl)isocyanurat oder deren Kombination ist und
die Menge an dem Halogenid in dem Flussmittel eine ausgewählt aus der Liste bestehend aus:
i. nicht weniger als 1,4 Gew.-% und nicht mehr als 1,9 Gew.-%; und
ii. nicht weniger als 2 Gew.-% und nicht mehr als 4 Gew.-%;
ist.

2. Flussmittel für Röhrenlot gemäß Anspruch 1, **dadurch gekennzeichnet, dass** das Halogenid mit nicht weniger als 2 Gew.-% und nicht mehr als 4 Gew.-% enthalten ist.

3. Röhrenlot, bei dem Flussmittel in einem Lötdraht eingeschlossen ist, wobei das Flussmittel enthält:
Kolophonium;
eine hochmolekulare Verbindung, die Erhöhen der Schmelzviskosität des Flussmittels verhindert und Flussmittelrückstand Aufweisen von Flexibilität nach Erhitzen durch Löten ermöglicht; und
Halogenid, das Erhöhen der Schmelzviskosität des Flussmittels verhindert und durch eine Kombination mit der hochmolekularen Verbindung, die dem Flussmittelrückstand Aufweisen von Flexibilität nach Erhitzen durch das Löten ermöglicht, dem Flussmittel ermöglicht, eine Oberfläche von während des Erhitzens durch das Löten geschmolzenem Lot zu bedecken,
wobei die hochmolekulare Verbindung eine von Polyethylenwachs, Harz auf Polyolefinbasis, Ethylen-Acrylsäure-Copolymer, Polyamidharz, Polyimidharz, Polypropylen, Polybutadien und Acrylharz oder deren Kombinationen ist, wobei die hochmolekulare Verbindung mit nicht weniger als 40 Gew.-% und nicht mehr als 60 Gew.-% enthalten ist,
das Halogenid eines von 2,2,2-Tribromethanol, Tetrabromethan, Tetrabrombutan, Dibrompropanol, n-2,3-Dibrom-1,4-butandiol, trans-2,3-Dibrom-2-buten-1,4-diol, Tris(2,3-dibrompropyl)isocyanurat oder deren Kombination ist und
die Menge an dem Halogenid in dem Flussmittel eine ausgewählt aus der Liste bestehend aus:
i. nicht weniger als 1,4 Gew.-% und nicht mehr als 1,9 Gew.-%; und
ii. nicht weniger als 2 Gew.-% und nicht mehr als 4 Gew.-%;
ist.

## Revendications

1. Flux pour métal d'apport en fil avec âme en flux contenant :
de la colophane ;
un composé à haut poids moléculaire qui empêche la viscosité à l'état fondu du flux d'augmenter et permet à un résidu de flux d'avoir de la souplesse après chauffage par brasage ; et
un halogénure qui empêche la viscosité à l'état fondu du flux d'augmenter et par une combinaison avec le composé à haut poids moléculaire qui permet au résidu de flux d'avoir de la souplesse après le chauffage par le brasage, permet au flux de recouvrir une surface de métal d'apport fondu pendant le chauffage par le brasage,
le composé à haut poids moléculaire étant n'importe quel composé parmi une cire de polyéthylène, une résine à base de polyoléfine, un copolymère éthylène-acide acrylique, une résine de polyamide, une résine de polyimide, du polypropylène, du polybutadiène et une résine acrylique ou leur combinaison, le composé à haut poids moléculaire étant présent à pas moins de 40 % en poids et pas plus de 60 % en poids,
l'halogénure étant n'importe quel composé parmi le 2,2,2-tribromoéthanol, le tétrabromoéthane, le tétrabromobutane, le dibromopropanol, le n-2,3-dibromo-1,4-butanediol, le trans-2,3-dibromo-2-butène-1,4-diol, le tris(2,3-dibromopropyl)isocyanurate ou leur combinaison, et
la quantité d'halogénure dans le flux étant une quantité choisie dans la liste constituée par :
i. pas moins de 1,4 % en poids et pas plus de 1,9 % en poids ; et
ii. pas moins de 2 % en poids et pas plus de 4 % en poids.

2. Flux pour métal d'apport en fil avec âme en flux selon la revendication 1 **caractérisé en ce que** l'halogénure est présent à pas moins de 2 % en poids et pas plus de 4 % en poids.

3. Métal d'apport en fil avec âme en flux dans lequel le flux est scellé dans un métal d'apport en fil,
le flux contenant :
de la colophane ;
un composé à haut poids moléculaire qui empêche la viscosité à l'état fondu du flux d'augmenter et permet à un résidu de flux d'avoir de la souplesse après chauffage par brasage ; et
un halogénure qui empêche la viscosité à l'état fondu du flux d'augmenter et par une combinaison avec le composé à haut poids moléculaire qui permet au résidu de flux d'avoir de la souplesse après chauffage par le brasage, permet au flux de recouvrir une surface de métal d'apport fondu pendant le chauffage par le brasage,
le composé à haut poids moléculaire étant n'importe quel composé parmi une cire de polyéthylène, une résine à base de polyoléfine, un copolymère éthylène-acide acrylique, une résine de polyamide, une résine de polyimide, du polypropylène, du polybutadiène et une résine acrylique ou leur combinaison, le composé à haut poids moléculaire étant présent à pas moins de 40 % en poids et pas plus de 60 % en poids,
l'halogénure étant n'importe quel composé parmi le 2,2,2-tribromoéthanol, le tétrabromoéthane, le tétrabromobutane, le dibromopropanol, le n-2,3-dibromo-1,4-butanediol, le trans-2,3-dibromo-2-butène-1,4-diol, le tris(2,3-dibromopropyl)isocyanurate ou leur combinaison ; et
la quantité d'halogénure dans le flux étant une quantité choisie dans la liste constituée par :
i. pas moins de 1,4 % en poids et pas plus de 1,9 % en poids ; et
ii. pas moins de 2 % en poids et pas plus de 4 % en poids.
